**Europäisches Patentamt**

**European Patent Office**

**Office européen des brevets**

(19)

(11) Veröffentlichungsnummer: **0 393 359**
**A2**

## (12) EUROPÄISCHE PATENTANMELDUNG

(21) Anmeldenummer: **90105065.8**

(22) Anmeldetag: **17.03.90**

(51) Int. Cl.5: **H03K 17/95**

(30) Priorität: **20.04.89 DE 3912946**

(43) Veröffentlichungstag der Anmeldung:
**24.10.90 Patentblatt 90/43**

(84) Benannte Vertragsstaaten:
**CH DE FR GB IT LI**

(71) Anmelder: **Werner Turck GmbH & Co. KG**
**Goethestrasse 7**
**D-5884 Halver(DE)**

(72) Erfinder: **Tigges, Burkhard**
**Zur Rieke 1**
**D-5768 Sundern(DE)**

(74) Vertreter: **Peerbooms, Rudolf, Dipl.-Phys.**
**Postfach 200 208 Dickmannstrasse 45c**
**D-5600 Wuppertal 2(DE)**

(54) **Induktiver Näherungsschalter.**

(57) Ein induktiver, auf Eisen- und Nichteisenmetall in gleicher Empfindlichkeit ansprechender Näherungsschalter weist einen Oszillator (1) einen Schwingkreis (4) mit einer Sensorspule (8) und eine Auswerteschaltung (5, 6) zur Ableitung der Schaltzustände aus dem Impedanzwert des Schwingkreises (4) auf.

Zur Erzielung einer hohen Ansprechempfindlichkeit und kleiner Bauformen ist ein frequenz- und amplitudenkonstanter, von außen nicht beeinflußbarer Oszillator (1), z.B. Quarzoszillator vorgesehen, dessen Frequenz nahe bei der Eigenfrequenz des Sensorschwingkreises (4) liegt und der über eine Impedanz (3) an den Sensorschwingkreis (4) angekoppelt ist.

Fig.1

EP 0 393 359 A2

## Induktiver Näherungsschalter

Die Erfindung betrifft einen induktiven Näherungsschalter gemäß Oberbegriff von Patentanspruch 1.

Ein solcher durch die DE-PS 37 14 433 bekannter Näherungsschalter hat die besondere Eigenschaft, bei der Annäherung von elektrisch leitfähigen, unmagnetischen Nichteisenmetallen (NF) und von ferromagnetischen Metallen (FE) den gleichen Schaltabstand aufzuweisen. Bei dem dort verwendeten LC-Oszillator treten jedoch noch deutliche Frequenzschwankungen auf, die zu unterschiedlichen Schaltabständen für NF- und FE-Auslösern führen können.

Bei der Annäherung von elektrisch leitfähigen Teilen an eine Spule verringert sich die wirksame Induktivität, weil aufgrund der durch die magnetische Induktion sich im leitfähigen Teil ausbildenden elektrischen Ströme eine Gegeninduktivität aufgebaut wird. Weiter wird bei der Annäherung von elektrisch leitfähigen Teilen die Spulengüte wegen der ohmschen Verluste im leitfähigen Teil herabgesetzt. Diese Eigenschaften werden in vielfältiger Weise bei Näherungsschaltern benutzt, indem die Verminderung der Amplitude oder das Aussetzen der Schwingung eines Oszillators durch die Bedämpfung der Sensorspule bei der Annäherung von elektrisch leitfähigen Teilen als Kriterium für eine entsprechende Annäherung ausgewertet wird. Dabei wird die Veränderung der Schwingfrequenz infolge der durch die Annäherung verringerten Induktivität kaum zur Auswertung mit herangezogen.

Bei der Annäherung von ferromagnetischen Teilen, also von Teilen mit sehr hoher magnetischer Leitfähigkeit, sind die oben beschriebenen aus der elektrischen Leitfähigkeit sich ergebenden Effekte überlagert durch eine Erhöhung der Induktivität als Folge der durch die ferromagnetischen Eigenschaften erhöhten Permeabilität der Spulenanordnung. Auch diese Eigenschaften werden bei Näherungsschaltern benutzt, meist in ähnlicher Weise wie oben beschrieben.

Die unterschiedlichen Wirkungen bei der Annäherung von elektrisch leitfähigen nichtmagnetischen Teilen, also insbesondere von Nichteisenmetallen wie Kupfer, Aluminium usw., im folgenden NF-Metalle genannt, und von ferromagnetischen Teilen, also insbesondere von Eisen-Metallen, im folgenden FE-Metalle genannt, können im Einzelfall gleichgültig sein, insbesondere wenn der Näherungsschalter nur die Annäherungen an stets gleiches Material detektieren soll. Die unterschiedlichen Wirkungen können aber auch nützlich sein, insbesondere wenn die Anordnung weniger zur Detektion einer bestimmten Annäherung verwendet werden soll, sondern vielmehr zur Unterscheidung der angenäherten Teile bezüglich ihres Materiales. Schließlich gibt es auch Fälle, in denen die unterschiedlichen Wirkungen nachteilig sind, insbesondere dann, wenn die Detektion auf einen bestimmten Annäherungszustand unabhängig von den unterschiedlichen Materialien erfolgen soll, was Ziel der vorliegenden Erfindung ist.

Bei dem für diesen Zweck bekannten Näherungsschalter (DE-PS 37 14 433) ist in einer Schwingkreis-Oszillatoranordnung außer dem im wesentlichen die Frequenz bestimmenden Frequenz-Schwingkreis ein Impedanzglied enthalten, und der Impedanzwert dieses Gliedes wird als auslösendes Material verwendet. Dabei sind die Resonanzfrequenz des Frequenz-Schwingkreises und der kritische Impedanzwert des Impedanzgliedes auf die Koordination des Schnittpunktes der für jeweils gleichen Schaltabstand sich ergebenden Impedanz/Frequenz-Kennlinie für Auslösung durch NF-Metall einerseits und durch FE-Metall andererseits abgestimmt.

Der Erfindung liegt die Aufgabe zugrunde, den gattungsgemäßen Näherungsschalter hinsichtlich identischer Ansprechempfindlichkeit auf NF- und FE-Auslöser zu optimieren und darüber hinaus hinsichtlich Temperaturstabilität und kleinerer Bauform zu verbessern.

Diese Aufgabe ist erfindungsgemäß durch die Merkmale des Kennzeichens von Anspruch 1 gelöst. Durch die Verwendung eines Oszillators, der durch einen Keramik-oder Quarzschwinger gesteuert wird, also beispielsweise eines Quarzoszillators, ist eine um etwa 2 bis 3 Zehnerpotenzen größere Frequenzkonstanz im Vergleich zu den bisher verwendeten LC-Oszillatoren erreicht, mit der Folge, daß der erfindungsgemäße Näherungsschalter exakt mit der für den kritischen Ansprechpunkt verlangten Frequenz (fo) betrieben wird und von daher keine Abweichungen mehr hinsichtlich der Ansprechempfindlichkeit für NF- und FE-Auslöser auftreten. Darüber hinaus zeichnen sich solche Quarz oszillatoren durch eine hohe Temperaturstabilität und in Folge ihrer typischen Einkapselung durch eine hohe Unempfindlichkeit gegenüber äußeren Einflüssen wie Luftfeuchtigkeit, durch hohe Langzeitstabilität und durch kleine Bauform aus. Es ist zwar bei Näherungsschaltern (DE-PS 32 21 888 und DE-OS 33 20 509), die unterschiedlich auf NF- und FE-Auslöser ansprechen, bekannt, diese dadurch unabhängiger von äußeren Einflüssen wie Feuchtigkeit, Temperatur oder Bauelementeänderungen zu machen, indem man die Frequenz des Oszillators der Resonanzfrequenz des Sensorschwingkreises nachregelt. Diese Maßnahme kann aber beim gattungsgemäßen Näherungsschalter nicht angewendet werden, da ja hier gerade die Einhaltung einer konstanten Oszillatorfrequenz Voraussetzung für eine identische Ansprechempfindlichkeit auf NF- und FE-Auslöser ist. Bei der Erfindung ist der Oszillator lose, d. h. im wesentlichen rückwirkungsfrei, an den Sensorschwingkreis angeschlossen, so daß auch eine schaltungsinterne Beeinflussung der Oszillatorfrequenz ausgeschlossen ist. Durch die bei der Erfindung ferner noch vorgesehene Abweichung zwischen der Eigenresonanzfrequenz des ungedämpften Sensorschwingkreises und der vom Oszillator an den Schwingkreis gelieferten Frequenz ist der Arbeitspunkt des Näherungsschalters vom Scheitelbereich der Kennlinie zu einem steilen Flankenbereich hin verlegt, so daß zugleich eine hohe Ansprechempfindlichkeit erreicht ist.

Die eigentliche Sensorspule, also die Spule, die durch die Annäherungen beeinflußtwerden soll, ist Teil eines Schwingkreises, der lose, also im wesentlichen rück wirkungsfrei an den Oszillator angekoppelt ist. Die Impedanz dieses Schwingkreises bei der durch die Oszillatorfrequenz vorgegebenen Frequenz wird dabei als Maß für den Grad der Annäherung einer Auswertestufe zugeführt. Die jeweilige Impedanz des Sensorschwingkreises hängt ab von seiner Dimensionierung und ferner von den durch die Annäherungen hervorgerufenen Änderungseffekten. Bei geeigneter Dimensionierung des Sensorschwingkreises schneidet sich die Impedanz/Frequenz-Kennlinie für eine bestimmte Annäherung von NF-Metallen mit derjenigen für eine gleiche Annäherung von FE-Metallen an einem Punkt, also bei einer bestimmten Frequenz und einer bestimmten Impedanz, im folgenden kritischer Punkt genannt. Wird nun die gesamte Anordnung so dimensioniert, daß die Frequenz am kritischen Punkt mit der Oszillatorfrequenz übereinstimmt und daß der Pegeldetektor bei der Impedanz am kritischen Punkt anspricht, so ist ein Näherungsschalter gegeben, der bei der Annäherung von NF-Auslösern und von FE-Auslösern jeweils beim gleichen Maß der Annäherung anspricht.

Für die erfindungsgemäße Anordnung kann es besonders zweckmäßig sein, den Sensorschwingkreis als Teil eines aktiven Bandpaßfilters zu betreiben. Damit wird es möglich, mit sehr schwachen Oszillatorsignalen auszukommen und das gewünschte Übertragungsverhalten des Bandpaßfilters in weiten Grenzen einzustellen. Die Ansprechempfindlichkeit kann bei gleichzeitiger Verminderung der Abstandsabweichungen erheblich gesteigert werden.

Da die Frequenz des Sensorschwingkreises am kritischen Punkt mit der Oszillatorfrequenz übereinstimmen soll, wird die Grundfrequenz des Sensorschwingkreises, also seine Frequenz im unbeeinflußten Zustand, zwar von der Oszillatorfrequenz abweichen müssen, aber nur wenig. Um die erforderliche Übereinstimmung bezüglich der Frequenz am kritischen Punkt jeweils richtig zu erzielen, kann prinzipiell die Oszillatorfrequenz oder die Grundfrequenz des Sensorschwingkreises entsprechend eingestellt oder bemessen werden. Zur Einstellung der für den Sensorschwingkreis wirksamen Anregungsfrequenz kann die ursprüngliche Oszillatorfrequenz auch durch einen entsprechenden Frequenzteiler herabgesetzt werden.

Um die erforderliche Übereinstimmung bezüglich der Impedanz am kritischen Punkt und dem Auslösepunkt des Pegeldetektors jeweils richtig zu erzielen, kann prinzipiell der Schaltpunkt des Pegeldetektors oder die Verstärkung des Bandpaßfilters oder, durch Zufügen ohmscher Anteile, die Impedanz des Sensorstromkreises oder aber die Amplitude des Oszillators oder die Impedanz der Kopplung entsprechend eingestellt oder bemessen werden.

Weitere Merkmale der Erfindung sind in den Unteransprüchen angegeben und werden nachfolgend anhand der Fig. 1 bis 3 näher erläutert. In der Zeichnung zeigt:

Fig. 1 das Blockschaltbild eines erfindungsgemäßen Näherungsschalters,

Fig. 2 das Diagramm eines typischen Verhaltens von Parallelschwingkreisen bei der Annäherung von verschiedenen Materialien auf einen bestimmten Abstand,

Fig. 3a bis 3d verschiedene Möglichkeiten für die Ankopplung des Sensorschwingkreises bzw. Bandpaßfilters an den Oszillator,

Fig. 4 eine weitere Ankopplungsmöglichkeit unter Verwendung eines Spannungs-Strom-Wandlers und

Fig. 5 und 6 zwei Ausführungsbeispiele für eine temperaturabhängige Nachregelung des Pegeldetektors nach Blockschaltbild Fig. 1.

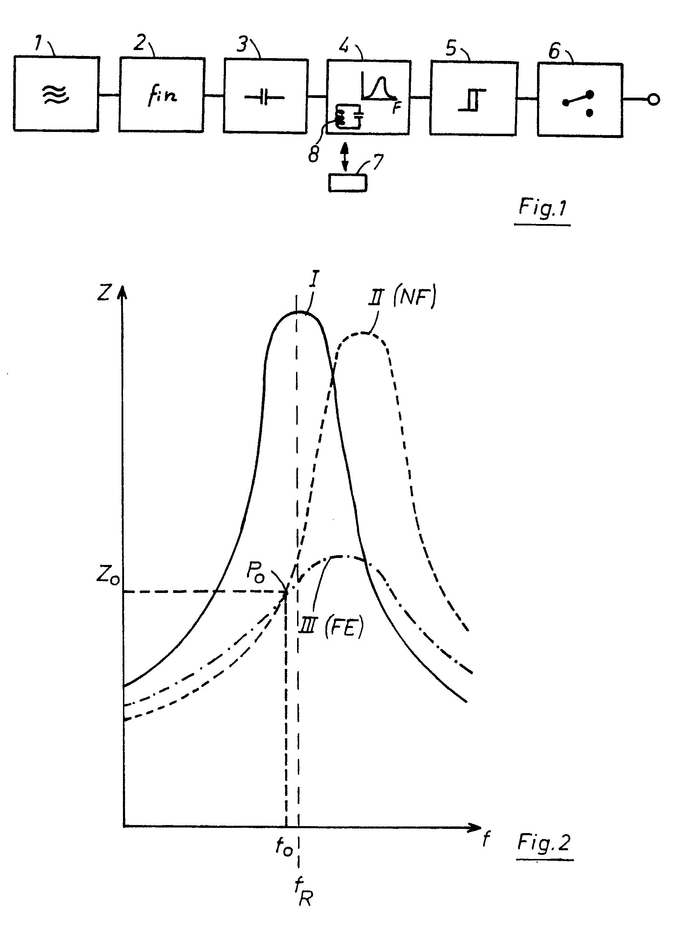

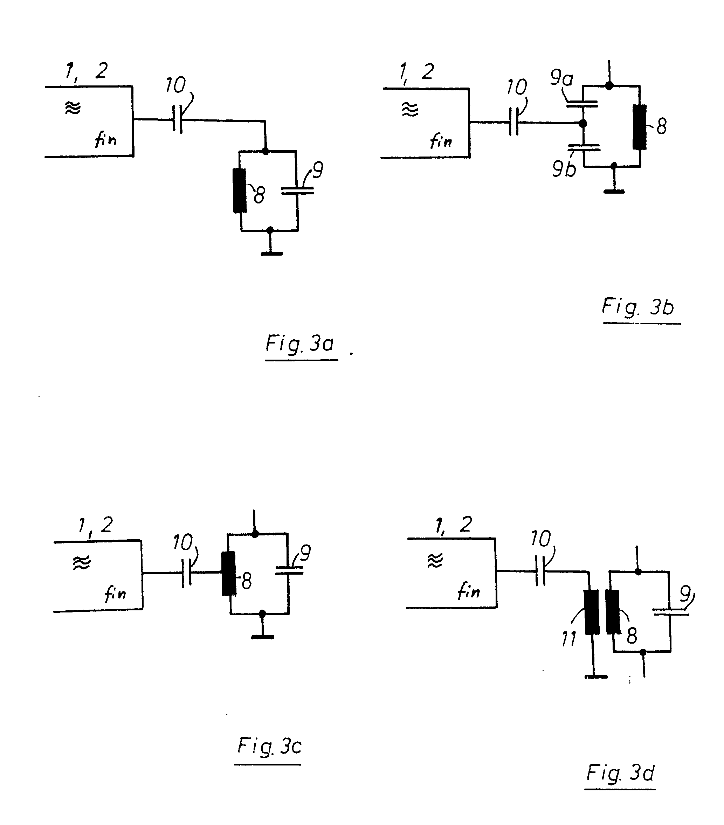

Der in Fig. 1 gezeigte Oszillator 1 kann prinzipiell ein Oszillator jeder Art sein, insbesondere aber auch ein Quarzoszillator. Seine Ausgangsfrequenz kann entweder unmittelbar zur Ankopplung 3 oder über einen festen oder einstellbaren Frequenzteiler 2 geführt sein. Die Ankopplung 3 kann prinzipiell jeder Art sein, insbesondere aber eine lose Kopplung mittels einer Impedanz, z.B. nach den in Fig. 3 gezeigten Beispielen. An dem am Oszillator 1 unmittelbar oder nach entsprechender Frequenzteilung 2 über die Kopplung 3 vorzugsweise lose angekoppelten Sensorschwingkreis 4 entsteht ein von der Einkopplung und von der jeweiligen Impedanz des Sensorschwingkreises 4 abhängiges Signal, das von einem Pegeldetektor 5 und einer Schaltstufe 6 in das Ausgangssignal des erfindungsgemäßen Näherungsschalters umgesetzt wird. Da die Impedanz des Sensorschwingkreises in bereits beschriebener Weise von der Annäherung 7 abhängig ist, wird das Ausgangssignal des Näherungsschalters entsprechend der Annäherung ausgelöst.

Der Sensorschwingkreis 4 kann ein einfacher LC-Schwingkreis sein, dessen Spule 8 in bekannter Weise als Sensorspule ausgebildet ist. Anstelle dieser einfachen Anordnung kann es aber erfindungsgemäß besonders vorteilhaft sein, den Schwingkreis als Teil eines aktiven schmalbandigen Bandpaßfilters zu betreiben. Dabei werden die Schalteigenschaften besonders stabil und es kann ein Oszillator mit geringer Leistung verwendet werden.

Fig. 2 zeigt eine Impedanz/Frequenz-Kennlinie für verschiedene Zustände. Die Kurve I zeigt die Impedanz eines unbeeinflußten Schwingkreises in Abhängigkeit von der Frequenz, wobei dem Scheitelpunkt die Eigenresonanzfrequenz $f_R$ zukommt. Die Kurve II zeigt den typischen Verlauf beim gleichen Schwingkreis, wenn dieser durch eine Annäherung eines NF-Metalles, also eines elektrisch leitfähigen, nichtmagnetischen Teiles, auf einen bestimmten Abstand beeinflußt ist. Die Resonanzfrequenz und der Höchstwert der Impedanz sind durch die Beeinflussung verändert. Kurve III schließlich zeigt den Verlauf bei der Annäherung eines FE-Metalles, also eines ferromagnetischen Teiles, auf genau den gleichen Abstand wie bei Kurve II. Bei der gezeigten gleichen Annäherung eines NF-Teiles und eines FE-Teiles ergibt sich ein Schnittpunkt $P_o$ der beiden Kurven II und III bei der Frequenz $f_o$ und bei der Impedanz $Z_o$. Wird nun ein solcher Schwingkreis als Sensorschwingkreis 4 mit genau der konstanten Frequenz $f_o$ angeregt und wird der Schaltpunkt des Pegeldetektors 5 auf den Impedanzwert $Z_o$ eingestellt, so wird der damit hergestellte erfindungsgemäße Näherungsschalter sowohl bei der Annäherung von NF-Metallen als auch von FE-Metallen beim gleichen Abstand schalten.

In Fig. 3 sind verschiedene Möglichkeiten für die vorzugsweise lose Ankopplung 3 des Sensorschwingkreises 4 an den frequenzkonstanten Oszillator 1, bzw. soweit vorhanden, zugehörigen Frequenzteiler 2, dargestellt. Fig. 3a zeigt eine einfache kapazitive Ankopplung. Die Sensorspule 8 und der Kondensator 9 bilden den Sensorschwingkreis 4, ggfs. auch als Teil eines aktiven Filters. Der Kondensator 10 bildet die Impedanz der Ankopplung 3 an den Oszillator 1 bzw. den Frequenzteiler 2. Fig. 3b zeigt eine kapazitive Kopplung, bei der der Schwingkreiskondensator 9 in zwei Teile 9a und 9b aufgeteilt ist und die Ankopplung dazwischen erfolgt. In Fig. 3c erfolgt die kapazitive Ankopplung mittels des Kondensators 10 als Impedanz auf einen Abgriff der Schwingkreisspule 8. Eine induktive Ankopplung ist in Fig. 3d gezeigt.

Dabei wird die Schwingungsanregung induktiv über die magnetische Kopplung der über den Kondensator 10 mit dem Oszillator verbundenen Erregerspule 11 mit der Sensorschwingkreisspule 8 übertragen.

Die Schwingungsanregung des Schwingkreises kann beim aktiven Bandpaß auch an geeigneter Stelle im Verstärkerzweig erfolgen.

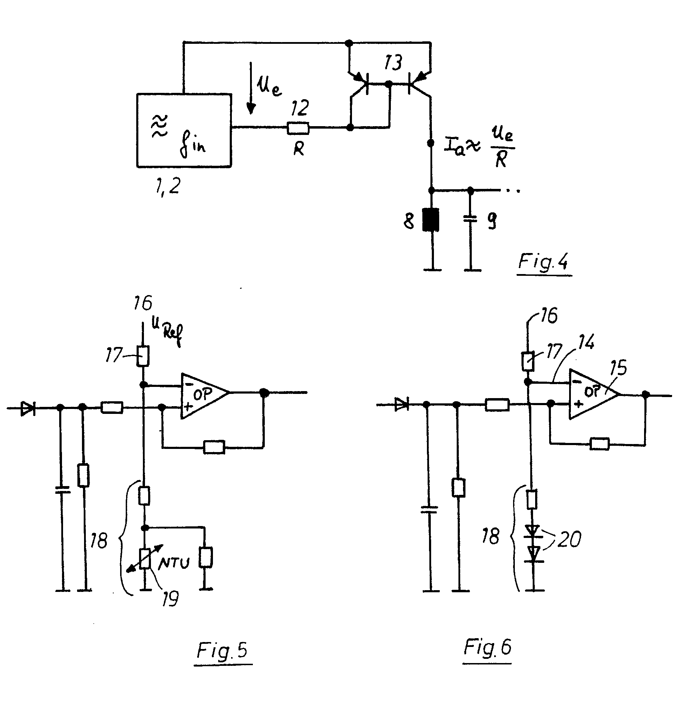

Eine weitere Ankopplungsmöglichkeit für die Ankopplung 3 des aus Spule 8 und Kondensator 9 bestehenden Sensorschwingkreises 4 ist in Fig. 4 gezeigt. Dabei wird die Ausgangsspannung $U_e$ des Oszillators 1 bzw. des Freqenzteilers 2 über den Widerstand 12 und einen aus den Transistoren 13 gebildeten Spannungs-Stromwandler auf den Sensorschwingkreis 8, 9 geführt. Der Spannungs-Stromwandler bewirkt eine Umsetzung des Spannungsverlaufes $U_e$ am Oszillator-bzw. Frequenzteilerausgang in einen proportionalen Stromverlauf $I_a$. Der so gebildete Strom bildet die Speisung des Sensorschwingkreises 8, 9. Diese Ankopplung wirkt verstärkend und ist damit besonders rückwirkungsfrei. Wegen der dabei wirksamen Verstärkung ist die Verwendung von Oszillatorschaltungen mit sehr geringer Leistung möglich.

Die Fig. 5 und 6 zeigen spezielle Möglichkeiten auf, um durch eine temperaturabhängige Nachregelung des Pegeldetektors 5 nach Blockschaltbild Fig. 1 die im Pegeldetektor selbst und auch die in der übrigen Anordnung enthaltenen störenden Temperaturabhängigkeiten zu kompensieren. Dazu wird die am Minuseingang 14 des Operationsverstärkers 15 als Sollwert für den Auslösepegel des Pegeldetektors 5 anliegende Spannung temperaturabhängig gemacht, indem in den aus einer Referenzspannung 16 gespeisten Spannungsteiler, der aus einem Widerstand 17 und einer Widerstandsstrecke 18 besteht, in die Widerstandsstrecke 18 temperaturabhängige Komponenten 19, 20 eingefügt werden. In Fig. 5 ist für diesen Zweck beispielhaft die Verwendung eines temperaturabhängigen Widerstandes 19, vorwiegend mit negativem Temperaturkoeffizienten, gezeigt. In besonders einfacher Weise kann die Temperaturabhängigkeit auch durch die Temperaturabhängigkeit von Halbleiterstrecken 20 nach Fig. 6 erfolgen, insbesondere wenn eben die Temperaturabhängigkeit von Halbleiterstrecken an anderen Stellen der Schaltung kompensiert werden soll. Durch diese Maßnahmen werden die Eigenschaften des Näherungsschalters weiter verbessert, indem die systematischen Temperaturabhängigkeiten der Anordnung weitestgehend aufgehoben werden.

## Ansprüche

1. Induktiver Näherungsschalter, mit einem frequenzkonstant arbeitenden Oszillator (1), mit einer von einem elektrisch leitfähigen Nichteisenmetall (NF)- und/oder einem ferromagnetischen Metall (FE)-Auslöser (7) beeinflußbaren, in einem Schwingkreis (4) liegenden Sensorspule (8) und mit einer Auswerteschaltung (5, 6), die die Schaltzustände aus dem Impedanzwert des Schwingkreises (4) ableitet, wobei die Frequenz des Oszillators (1) und der kritische Impedanzwert des Sensorschwingkreises (4) auf die Koordination $(f_o, Z_o)$ des Schnittpunktes $(P_o)$ der für jeweils gleichen Schaltabstand sich ergebenden Imoedanz/Frequenz-Kennlinien (II, III) für einen NF-Auslöser und einen FE-Auslöser abgestimmt sind, dadurch gekennzeichnet,

a) daß der Oszillator (1) durch einen Keramik-oder Quarzschwinger gesteuert wird und von außen selbst nicht beeinflußbar ist,

b) daß der Oszillator (1) lose, d. h. im wesentlichen rückwirkungsfrei, an den Sensorschwingkreis (4) angeschlossen ist,

c) daß der Oszillator (1) amplitudenkonstant arbeitet und

d) daß die Eigenresonanzfrequenz $(f_R)$ des ungedämpften Sensorschwingkreises (4) um einen geringen Betrag von der vom Oszillator (1) an den Sensorschwingkreis (4) gelieferten Frequenz $(f_o)$ abweicht.

2. Näherungsschalter nach Anspruch 1, dadurch gekennzeichnet, daß die Frequenz des Oszillators (1) einstellbar ist.

3. Näherungsschalter nach Anspruch 1 oder 2, dadurch gekennzeichnet, daß die Amplitude des Oszillators (1) einstellbar ist.

4. Näherungsschalter nach einem oder mehreren der Ansprüche 1 bis 3, dadurch gekennzeichnet, daß die Eigenresonanzfrequenz $(f_R)$ des Sensorschwingkreises (4) einstellbar ist.

5. Näherungsschalter nach einem oder mehreren der Ansprüche 1 bis 4, dadurch gekennzeichnet, daß zwischen dem Oszillator (1) und der Koppelimpedanz (3) ein fester oder einstellbarer Frequenzteiler (2) angeordnet ist.

6. Näherungsschalter nach einem oder mehreren der Ansprüche 1 bis 5, dadurch gekennzeichnet, daß der Sensorschwingkreis (4) Teil eines aktiven schmalbandigen Bandpaßfilters ist.

7. Näherungsschalter nach einem oder mehreren der Ansprüche 1 bis 6, dadurch gekennzeichnet, daß die Güte des Sensorschwingkreises (4) durch Zuschalten von festen oder einstellbaren ohmschen Anteilen einstellbar ist.

8. Näherungsschalter nach Anspruch 6, dadurch gekennzeichnet, daß die Verstärkung des aktiven Bandpaßfilters einstellbar ist.

9. Näherungsschalter nach einem oder mehreren der Ansprüche 1 bis 8, dadurch gekennzeichnet, daß die Schaltpunkte des Pegeldetektors (5) einstellbar sind.

10. Näherungsschalter nach einem oder mehreren der Ansprüche 1 bis 9, dadurch gekennzeichnet, daß zur Kompensation von Temperaturabhängigkeiten des Pegeldetektors (5) und aller übrigen Komponenten des Näherungsschalters eine absichtliche, entgegengesetzte Temperaturabhängigkeit der Schaltpunkte durch temperaturabhängige Komponenten (19, 20) herbeigeführt wird.

11. Näherungsschalter nach Anspruch 1, dadurch gekennzeichnet, daß der Schwingkreis kapazitiv über einen Kondensator (10) an den Oszillator (1) angekoppelt ist (Fig. 3a).

12. Näherungsschalter nach Anspruch 11, dadurch gekennzeichnet, daß der Schwingkreiskondensator (9) in zwei Teile (9a, 9b) aufgeteilt ist und daß die Ankopplung zwischen diesen Teilen erfolgt (Fig. 3b).

13. Näherungsschalter nach Anspruch 11, dadurch gekennzeichnet, daß die Ankopplung an einem Abgriff der Schwingkreisspule (8) erfolgt (Fig. 3c).

14. Näherungsschalter nach Anspruch 11, dadurch gekennzeichnet, daß die Ankopplung des Koppelkondensators (10) induktiv über eine Regelspule (11) an der Schwingkreisspule (8) erfolgt (Fig. 3d).

15. Näherungsschalter nach einem oder mehreren der Ansprüche 1 bis 10, dadurch gekennzeichnet, daß die Ankopplung des Sensorschwingkreises (8, 9) an den Oszillator (1) bzw. den Frequenzteiler (2) über einen Spannungs-Stromwandler (13) erfolgt.

_Fig.1_

_Fig.2_

Fig. 3a

Fig. 3b

Fig. 3c

Fig. 3d

Fig. 4

Fig. 5

Fig. 6